# EUROPÄISCHE PATENTSCHRIFT

(11) **EP 1 002 365 B1**
(45) Veröffentlichungstag und Bekanntmachung des Hinweises auf die Patenterteilung: **19.06.2002**
(21) Anmeldenummer: 98922607.1
(22) Anmeldetag: 17.03.1998
(51) Int. Cl.: H03J 1/00

(54) **RDS-AF- TESTS IM NF-PEGELMINIMUM**
RDS FREQUENCY REPLACEMENT TESTS AT LOW FREQUENCY MINIMUM LEVEL
TESTS POUR FREQUENCE DE REMPLACEMENT RDS AU NIVEAU MINIMUM DE BASSE FREQUENCE

(30) Priorität: 07.08.1997 DE 19734168
(43) Veröffentlichungstag der Anmeldung: 24.05.2000
(73) Patentinhaber: ROBERT BOSCH GMBH, 70442 Stuttgart (DE)
(72) Erfinder: HEGELER, Wilhelm, D-31134 Hildesheim (DE)
(86) Internationale Anmeldenummer: DE9800785
(87) Internationale Veröffentlichungsnummer: WO9908382

(56) Entgegenhaltungen:
- EP-A- 0 502 500
- EP-A- 0 508 369

## Beschreibung

### Technisches Gebiet

Die Erfindung betrifft einen RDS-Rundfunkempfänger mit einer Steuereinheit, welche einen schlechten Empfang signalisierende Meßgrößen aufsummiert und mit einem vorbestimmten Schwellwert vergleicht und bei Überschreiten des vorbestimmten Schwellwertes durch das Signal einen AF-Test auslöst. Unter RDS ist dabei ein Radio-Daten-System (oder Signal), definiert in Tech. 3244-E von European Broadcasting Union (EBU), zu verstehen. Mit einem AF-Test wird eine Alternative Frequenz (AF), auf der dasselbe Programm gesendet wird, gesucht. Diese AF wird vom Gerät gelernt durch Erfahrung oder aus den RDS-Daten entnommen. Die Erfindung betrifft ferner ein Verfahren zum Auslösen eines AF-Testes bei einem RDS-Rundfunkempfänger, wobei eine Steuereinheit einen schlechten Empfang signalisierende Meßgrößen aufsummiert und dieses Signal A mit einem vorbestimmten Schwellwert vergleicht und bei Überschreiten des vorbestimmten Schwellwertes durch das tiefpaßgefilterte Signal ein AF-Test ausgelöst wird.

### Stand der Technik

Bei RDS-Rundfunkempfängern, wie beispielsweise RDS-Autoradios, ist es bekannt, bei schlechter Signal- bzw. Empfangsqualität einen Test für Alternativfrequenzen (AF-Test) durchzuführen und ggf. auf eine Alternativfrequenz zu wechseln, wenn sich dort eine bessere Signal- bzw. Empfangsqualität ergibt.

Besonders störend ist dieser AF-Test jedoch besonders während lauten Tönen, d. h. bei hohem NF-Pegel. Bei der Niederfrequenz (NF) handelt es sich daher um eine Niederfrequenz als die dem HF-Signal aufmodulierte Nutzinformation speziell auch der hörbare Anteil. Deshalb wird in der DE 42 33 758 A1 vorgeschlagen, diesen AF-Test nur in NF-Pausen durchzuführen. Dies hat jedoch den Nachteil, daß bei besonderen Musikrichtungen selten bis nie AF-Teste erfolgen können, da hier keine entsprechenden NF-Pausen vorhanden sind.

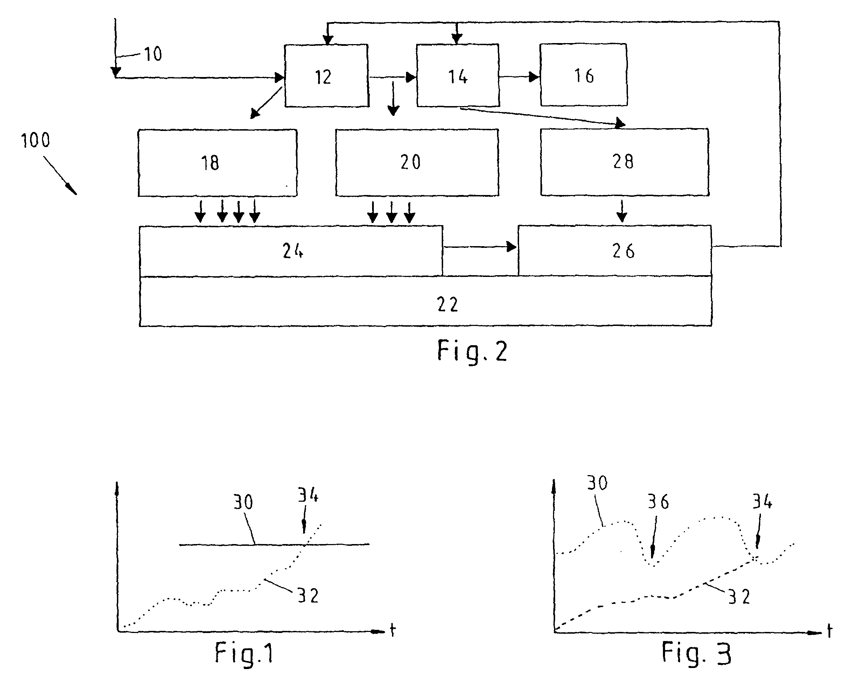

Bei einem RDS-Empfänger können die Meßgrößen für Signalstörungen akkumuliert werden und das akkumulierte Signal A mit einem vorbestimmten Schwellwert verglichen werden, wie dies in Fig. 1 dargestellt ist. Hierbei tritt jedoch der unerwünschte Effekt ein, daß einige Störungsdetektoren, wie beispielsweise "Multipath" für Mehrwegeempfang gerade bei großem FM-Hub, d. h. bei hohem NF-Pegel der Frequenzmodulation, eine hohe bzw. kräftige Störungsmeldung abgeben und damit eventuell einen AF-Test genau im ungünstigsten Moment, nämlich bei hohem NF-Pegel auslösen, wobei unter NF-Pegel der zeitliche Mittelwert des Betrages der NF-Amplitude verstanden wird. Der NF-Pegel kann in einem Mikroprozessor durch Zahlen dargestellt werden, deren Skalierung geeignet gewählt werden muß.

Aus DE-A-0 502 500 ist ein Verfahren zur Abstimmung eines Rundfunkempfängers in Abhängigkeit von Empfangsqualitätsmerkmalen und unter Ausnutzung der RDS-Informationen bekannt. In einer Alternativfrequenztabelle des Rundfunkempfängers gespeicherte Alternativfrequenzdaten werden entsprechend ihrer Empfangsqualität sortiert. Um zu gewährleisten, daß stets die am Empfängerstandort mit der bestmöglichen Empfangsqualität empfangbare Sendefrequenz eingestellt ist, wird die Empfangsqualität der aktuell eingestellten Frequenz regelmäßig mit der der in der Alternativfrequenztabelle abgespeicherten Frequenz(en) verglichen. Um ein zu häufiges Umschalten von der aktuellen auf eine alternative Sendefrequenz und die damit verbundenen Empfangsunterbrechungen zu vermeiden wird vorgeschlagen, einen Vergleich mit einer Alternativfrequenz dann durchzuführen, wenn die aktuell gemessene Qualitätsbewertungsinformation einen Schwellwert unterschreitet. Der Schwellwert wird derart gebildet, daß nach Einstellung einer Sendefrequenz deren Qualitätsbewertungsinformation über einen Zeitraum gemittelt, und der so bestimmte Mittelwert um einen vorgegebenen Wert vermindert wird, wobei der verminderte Mittelwert den Schwellwert bildet, der nach einer vorgegebenen Zeit wieder in Richtung des ursprünglichen Mittelwerts ansteigt.

### Darstellung der Erfindung, Aufgabe, Lösung, Vorteile

Es ist Aufgabe der vorliegenden Erfindung, einen verbesserten RDS-Rundfunkempfänger bzw. ein verbessertes Verfahren der obengenannten Art zur Verfügung zu stellen, welche die obengenannten Nachteile beseitigen und AF-Tests bevorzugt bei NF-Pausen auslöst, ohne daß ein Fehlen von NF-Pausen das Ausführen eines AF-Tests blockiert.

Diese Aufgabe wird durch einen RDS-Rundfunkempfänger der obengenannten Art mit den in Anspruch 1 gekennzeichneten Merkmalen bzw. durch ein Verfahren der obengenannten Art mit den in Anspruch 5 gekennzeichneten Merkmalen gelöst.

Dazu ist es erfindungsgemäß vorgesehen, daß ein Schwellwertgeber vorgesehen ist, welcher einen zeitlich variierenden Schwellwert vorgibt und der AF-Test bevorzugt in NF-Pausen erfolgt, wenn der Schwellwertgeber als Schwellwert ein Überlagerungssignal aus einem vorbestimmten konstanten Schwellwert und einem dem NF-Pegel proportionalen Signal vorgibt. Dies hat den Vorteil, daß eine flexible und situationsgerechte AF-Test-Auslösung erfolgt.

Vorzugsweise Weitergestaltungen des RDS-Rundfunkempfängers sind in den Ansprüchen 2 bis 4 beschrieben.

Es ergibt sich eine besonders einfache und wirkungsvolle Anordnung, wenn ein Inverter vorgesehen ist, welcher einen Niederfrequenz-Pegel, der proportional zu einem wiederzugebenden Audiosignal ist, invertiert und der Steuereinheit zuführt, welche dieses invertierte Signal dem Summensignal überlagert und einen AF-Test auslöst, sobald dieses Überlagerungssignal den Schwellwert überschreitet.

Bevorzugt sind die einen schlechten Empfang signalisierenden Meßgrößen vom HF-Signal und/oder den RDS-Signalen abgeleitet.

In vorteilhafter Weise ist als Akkumulator ein Tiefpaßfilter vorgesehen, in welchem sich die aufsummierten Meßgrößen akkumulieren.

Bei einem Verfahren der obengenannten Art wird erfindungsgemäß der Schwellwert oder das Signal A der Steuereinheit als zeitlich variierendes Signal zugeführt. Der AF-Test erfolgt bevorzugt in NF-Pausen, wenn der Schwellwert als ein Überlagerungssignal aus einem vorbestimmten konstanten Schwellwert und einem dem NF-Pegel proportionalen Signal gebildet wird. Dies hat den Vorteil, daß eine flexible und situationsgerechte AF-Test-Auslösung erfolgt.

Vorzugsweise Weitergestaltungen des Verfahrens sind in den Ansprüchen 6 bis 7 beschrieben.

In besonders vorteilhafter Weise werden dabei die einen schlechten Empfang signalisierenden Meßgrößen vom HF-Signal und/oder den RDS-Signalen abgeleitet. Dies ergibt eine zuverlässige Erkennung schlechter Signal- bzw. Empfangsqualität.

Bevorzugt akkumulieren sich die aufsummierten Meßgrößen nach der Tiefpaßfilterung in einem Akkumulator. Dies ermöglicht einen einfachen und schnellen Vergleich mit einem Schwellwert.

In einer weiteren vorteilhaften Ausbildung der Erfindung wird ein NF-Pegel, der einen zeitlichen Mittelwert des Betrages einer NF-Amplitude proportional ist, gebildet, invertiert und dem Signal (A) überlagert, wobei ein AF-Test ausgelöst wird, sobald dieses Überlagerungssignal den Schwellwert überschreitet.

### Kurze Beschreibung der Zeichnungen

Nachstehend wird die Erfindung anhand der beigefügten Zeichnungen näher erläutert. Diese zeigen in
- Fig. 1: eine Empfangssignalbewertung nach der Schwellwertmethode gemäß dem Stand der Technik,
- Fig. 2: ein Blockschaltbild einer bevorzugten Ausführungsform eines erfindungsgemäßen RDS-Rundfunkempfängers, und
- Fig. 3: eine Empfangssignalbewertung nach der Schwellwertmethode gemäß der Erfindung.

### Bester Weg zur Ausführung der Erfindung

Der in Fig. 2 als Blockschaltbild vereinfacht dargestellte RDS-Rundfunkempfänger 100 umfaßt eine Antenne 10, welche ein HF-Signal zur weiteren Verarbeitung in eine HF-Stufe 12 leitet. Dort wird das HF-Signal herabgemischt und gefiltert, demoduliert und das NF-Signal herausgefiltert. Dieses NF-Signal wird über eine NF-Stufe 14 einem Lautsprecher 16 zugeführt.

Aus dem HF-Signal werden an der HF-Stufe 12 verschiedene Meßgrößen von einer Meßstufe 18 abgeleitet. Die Meßstufe 18 umfaßt beispielsweise einen Multipath-Detektor, einen Nachbarkanal-Detektor, einen Feldstärkemesser oder einen Suchlaufstopp-Detektor. Je nach den empfangenen Meßsignalen gibt die Meßstufe 18 eine Störungsmeldung bzw. ein entsprechendes Signal an eine Steuereinheit 22 ab, welche eine schlechte Signal- bzw. Empfangsqualität anzeigt.

Ferner werden zwischen der HF-Stufe 12 und der NF-Stufe 14 von einem RDS-Dekoder 20 entsprechende Qualitätsinformationen abgeleitet. Derartige Qualitätsinformationen enthaltende Signale sind z.B. Synchronisation, Fehlerrate und PI-Häufigkeit (PI=Programmkettenkennung).

Die Signale aus der Meßstufe 18 und dem RDS-Dekoder 20 werden in der Steuerung 22 in einer Auswerteeinheit 24, beispielsweise einem Integrator, aufsummiert und einer Tiefpaßfilterung unterzogen. Das resultierende, sich akkumulierende Signal wird in einem Vergleicher 26 mit einem Schwellwert verglichen. Der Vergleicher 26 hat zusätzlich einen Eingang für einen Schwellwertgeber 28, welcher ein dem NF-Pegel aus der NF-Stufe 14 proportionales Signal mit einem konstanten Anteil mischt und somit ein über die Zeit variierendes Schwellwertsignal erzeugt und dem Vergleicher 26 zuführt.

Hierzu dient beispielsweise ein ohnehin bereits in einem RDS-Programm vorgesehener Integrator, in dem sog. "Strafpunkte" angesammelt werden, die sich aus diversen und geeignet bewerteten Störmeldungen, beispielsweise aus der Meßstufe 18 und dem RDS-Dekoder 20, und sonstiger Mängel der Signal- bzw. Empfangsqualität ergeben. Bei gutem Empfang läuft dieser Integrator langsam leer. Wenn jedoch das Mass voll ist und der Integrator eine Schwelle 30 erreicht, wird ein AF-Test ausgelöst.

Hierbei ist es wichtig, durch geeignete Bewertung der schlechten Empfang signalisierenden Meßgrößen, durch Summation verschiedener Einflüsse und Akkumulation der "Strafpunkte" (Tiefpaß) ein allgemeines, zeitabhängiges Qualitätsmaß zu erzeugen, das in bestmöglicher Weise die Qualität des empfangenen Signals bzw. die Empfangsqualität wiedergibt.

Dies ist graphisch in Fig. 3 dargestellt. Ein Schwellwertsignal 30 und ein Akkumulationssignal 32 verlaufen über die Zeit t. Das Schwellwertsignal 30 setzt sich dabei zusammen aus dem konstanten Schwellwert S und dem NF-Signal bzw. einem dem NF-Signal proportionalen Signal, welches nachfolgend als "NF-Pegel" oder in den Formeln kurz mit "NF" bezeichnet wird. Das Akkumulator- bzw. Akkumulationssignal 32, nachfolgend auch mit "A" bezeichnet, steigt mit der Zeit t mehr oder weniger schnell bzw. stark an. Eine Entscheidung für einen Test erfolgt an einem Punkt 34, wo das Akkumulationssignal 32 das Schwellwertsignal 30 schneidet. Wie sich unmittelbar ergibt, erfolgt dies mit höherer Wahrscheinlichkeit in einem NF-Minimum 36.

Die Höhe der konstanten Schwelle S kann von der Vorgeschichte abhängen. Erfindungsgemäß wird zusätzlich eine Abhängigkeit der Schwelle 30 vom NF-Pegel dadurch erreicht, daß der Integrator die Schwelle 30 vorzugsweise, d.h. mit höherer Wahrscheinlichkeit, bei kleinen Pegelwerten 36 erreicht. Beim Fehlen kleiner Pegelwerte 36 dauert das Auslösen des AF-Testes schlimmstenfalls etwas länger ist aber nicht auf Dauer blockiert. Hierbei erfolgt also ein AF-Test, wenn A > S + NF.

In einer besonders bevorzugten Alternative wird der NF-Pegel invertiert und dem Akkumulatorsignal A hinzu addiert. Hierbei erfolgt dann ein AF-Test, wenn dieses so erzeugte Signal größer als der Schwellwert S wird, d. h. wenn A - NF > S. In diesem Fall unterliegt durch die Addition des zeitlich mit Maxima und Minima variablen Signals NF des Akkumulatorsignal A entsprechenden zeitlichen Schwankungen. Bei großem NF-Pegel wird somit das Akkumulatorsignal "herabgezogen" und erhält einen größeren Abstand zum konstanten Schwellwert S. Wenn jedoch die im Akkumulatorsignal kumulierten Fehler bereits sehr groß sind oder während eines dauerhaft hohen NF-Signals werden, dann wird trotz einem entsprechend hohem NF-Pegel ein AF-Test ausgelöst. Dadurch ist ein dauerhaftes Blockieren eines AF-Testes auch für extrem schlechte Empfangsbedingungen bei hohem NF-Pegel wirksam vermieden und trotzdem eine entsprechende Abhängigkeit der AF-Test-Auslösung vom NF-Signal über den NF-Pegel gegeben.

Der NF-Pegel wird beispielsweise durch Gleichrichtung bzw. Sampeln der NF-Information bzw. des NF-Signals und Tiefpaßfilterung über ein Filter 1. Ordnung mit 2 verschiedenen Zeitkonstanten gewonnen. Die Zeitkonstanten betragen insbesondere für das schnelle Hochladen einige ms und für das langsame Entladen einige 100ms, wodurch eine obere Einhüllende des NF-Signals angenähert wird.

Ein ähnlicher Mechanismus ist auch bei den Feldstärkemessungen zur Orientierung in der Senderlandschaft realisierbar. Hier erfolgt die Messung bisher in einem starren Raster von z.B. 12 min. Erfindungsgemäß wird nunmehr ein Flag als Merker für dieses Vorhaben gesetzt während ein ohnehin vorhandener RDS-Gruppen-Zähler langsam von 0 hochläuft. Gestartet wird dann die Messung, sobald der Zählerstand eine dem NF-Pegel proportionale Zahl überschreitet. Auch dies geschieht mit größerer Wahrscheinlichkeit im Pegelminimum.

## Patentansprüche

1. RDS-Rundfunkempfänger (100) mit einer Steuereinheit (22), die einen schlechten Empfang signalisierende Meßgrößen aufsummiert und das Summensignal (A) mit einem vorgegebenen Schwellwert vergleiche und bei Überschreiten des Schwellwertes durch das Summensignal (A) einen Alternativfrequenztest auslöst,
**dadurch gekennzeichnet,**
**daß** ein Schwellwertgeber (28) vorgesehen ist, der als Schwellwert ein Überlagerungssignal aus einem vorbestimmten konstanten Schwellwert und einem dem Niederfrequenzpegel eines wiederzugebenden Audiosignals proportionalen Signal vorgibt.

2. RDS-Rundfunkempfänger (100) mit einer Steuereinheit (22), die einen schlechten Empfang signalisierende Meßgrößen aufsummiert und ein aus dem Summensignal abgeleitetes Signal mit einem vorgegebenen Schwellwert vergleicht und bei Überschreiten des Schwellwertes durch das aus dem Summensignal abgeleitete Signal einen Alternativfrequenztest auslöst,
**dadurch gekennzeichnet,**
**daß** ein Inverter vorgesehen ist, der einen Niederfrequenzpegel, der proportional zu einem wiederzugebenden Audiosignal ist, invertiert und der Steuerung (22) zuführt, die dieses invertierte Signal dem Summensignal überlagert und einen Alternativfrequenztest auslöst, sobald das Überlagerungssignal den Schwellwert (30) überschreitet.

3. RDS-Rundfunkempfänger (100) nach einem der vorhergehenden Ansprüche, dadurch gekennzeichet, daß die einen schlechten Empfang signalisierenden Meßgrößen vom empfangenen Rundfunksignal als HF-Signal und/oder von den RDS-Qualitätsinformationen vom RDS-Decoder (20) abgeleitet sind.

4. RDS-Rundfunkempfänger (100) nach einem der vorhergehenden Ansprüche, **dadurch gekennzeichnet, daß** ein Tiefpaßfilter vorgesehen ist, das das Summensignal (A) vor dem Vergleich tiefpaßfiltert.

5. Verfahren zum Auslösen eines Alternativfrequenztests bei einem RDS-Rundfunkempfänger, wobei eine Steuereinheit (22) einen schlechten Empfang signalisierende Meßgrößen aufsummiert und dieses Summensignal (A) mit einem Schwellwert vergleicht und bei Überschreiten des Schwellwerts durch das Summensignal (A) ein Alternativfrequenztest ausgelöst wird,
**dadurch gekennzeichnet,**
**daß** als Schwellwert ein Überlagerungssignal aus einem vorbestimmten konstanten Schwellwert und einem dem Niederfrequenzpegel eines wiederzugebenden Audiosignals proportionalen Signal vorgegeben wird.

6. Verfahren zum Auslösen eines Alternativfrequenztests bei einem RDS-Rundfunkempfänger, wobei eine Steuereinheit (22) einen schlechten Empfang signalisierende Meßgrößen aufsummiert und ein aus diesem Summensignal (A) abgeleitetes Signal mit einem Schwellwert vergleicht und bei Überschreiten des Schwellwerts durch das aus dem Summensignal (A) abgeleitete Signal ein Alternativfrequenztest ausgelöst wird, **dadurch gekennzeichnet, daß** ein Niederfrequenzpegel, der proportional zu einem wiederzugebenden Audiosignal ist, gebildet, invertiert und dem Summensignal (A) überlagert wird, wobei ein Alternativfrequenztest ausgelöst wird, sobald das Überlagerungssignal den Schwellwert überschreitet.

7. Verfahren nach einem der Ansprüche 6 oder 7, **dadurch gekennzeichnet, daß** die einen schlechten Empfang signalisierenden Meßgrößen vom HF-Signal und/oder den RDS-Qualitätssignalen des RDS-Dekoders (20) abgeleitet werden.

## Claims

1. RDS radio receiver (100) comprising a control unit (22) which adds together measured quantities signalling a poor reception and compares the aggregate signal (A) with a predetermined threshold value and, if the threshold value is exceeded by the aggregate signal (A), triggers an alternative frequency test, **characterized in that** a threshold value generator (28) is provided which delivers as threshold value a beat signal of a predetermined constant threshold value and a signal proportional to the audio frequency level of an audio signal to be reproduced.

2. RDS radio receiver (100) comprising a control unit (22) which adds together measured quantities signalling a poor reception and compares a signal derived from the aggregate signal with a predetermined threshold value and, if the threshold value is exceeded by the signal derived from the aggregate signal, triggers an alternative frequency test, **characterized in that** an inverter is provided which inverts an audio frequency level which is proportional to an audio signal to be reproduced, and supplies it to the controller (22) which beats this inverted signal with the aggregate signal and triggers an alternative frequency test as soon as the beat signal exceeds the threshold value (30).

3. RDS radio receiver (100) according to one of the preceding claims, **characterized in that** the measured quantities signalling a poor reception are derived as RF signal from the received radio signal and/or from the RDS quality information from the RDS decoder (20).

4. RDS radio receiver (100) according to one of the preceding claims, **characterized in that** a low-pass filter is provided which low-pass filters the aggregate signal (A) before the comparison.

5. Method for triggering an alternative frequency test in an RDS radio receiver, in which a control unit (22) adds together measured quantities signalling a poor reception and compares this aggregate signal (A) with a threshold value and, if the threshold value is exceeded by the aggregate signal (A), an alternative frequency test is triggered, **characterized in that**, as threshold value, a beat signal of a predetermined constant threshold value and a signal proportional to the audio frequency level of an audio signal to be reproduced is predetermined.

6. Method for triggering an alternative frequency test in an RDS radio receiver, in which a control unit (22) adds together measured quantities signalling a poor reception and compares a signal derived from this aggregate signal (A) with a threshold value and if the threshold value is exceeded by the signal derived from the aggregate signal (A) an alternative frequency test is triggered, **characterized in that** an audio frequency level which is proportional to an audio signal to be reproduced is formed, inverted and heterodyned with the aggregate signal (A), an alternative frequency test being triggered as soon as the beat signal exceeds the threshold value.

7. Method according to one of Claims 6 or 7, **characterized in that** the measured quantities signalling a poor reception are derived from the RF signal and/or the RDS quality signals of the RDS decoder (20).

## Revendications

1. Récepteur radiophonique RDS (100) comprenant une unité de commande (22) qui fait la somme des grandeurs de mesure signalant une mauvaise réception et qui compare le signal de somme (A) à un seuil prédéterminé et en cas de dépassement du seuil prédéterminé par le signal de somme (A), déclenche un test de fréquences alternatives,
**caractérisé par**
un générateur de seuil (28) qui génère, comme valeur de seuil, un signal de combinaison formé d'une valeur de seuil constante prédéterminée et d'un signal proportionnel au niveau basse fréquence du signal audio à reproduire.

2. Récepteur radiophonique RDS (100) comprenant une unité de commande (22) qui fait la somme des grandeurs de mesure signalant une mauvaise réception et le compare à une valeur de seuil prédéterminée par le signal déduit du signal somme, et en cas de dépassement de la valeur de seuil par le signal déduit du signal de somme, déclenche un test de fréquences alternatives,
**caractérisé par**
un inverseur qui inverse un niveau basse fréquence proportionnel au signal audio à reproduire et l'applique à la commande (22) combinant alors ce signal inversé au signal somme et déclenchant un test de fréquences alternatives dès que ce signal combiné dépasse le seuil (30).

3. Récepteur radiophonique RDS (100) selon l'une quelconque des revendications précédentes,
**caractérisé en ce que**
les grandeurs de mesure qui signalent une mauvaise réception sont déduites du signal radiophonique reçu comme signal HF et/ou des informations de qualité RDS fournies par le décodeur RDS (20).

4. Récepteur radiophonique RDS (100) selon l'une quelconque des revendications précédentes,
**caractérisé par**
un filtre passe-bas qui effectue un filtrage passe-bas du signal somme (A) avant la comparaison.

5. Procédé de déclenchement d'un test de fréquences alternatives dans un récepteur radiophonique RDS selon lequel
une unité de commande (22) additionne les grandeurs de mesure signalant une mauvaise réception et compare ce signal somme (A) à une valeur de seuil, et en cas de dépassement du seuil par le signal somme (A) déclenche un test de fréquences alternatives,
**caractérisé en ce que**
comme valeur de seuil on prédéfinit un signal de combinaison formé d'une valeur de seuil constante prédéterminée et d'un signal proportionnel au niveau basse fréquence du signal audio à reproduire.

6. Procédé de déclenchement d'un test de fréquences alternatives dans un récepteur radiophonique RDS selon lequel
une unité de commande (22) fait l'addition des grandeurs de mesure signalant une mauvaise réception et compare un signal déduit de ce signal somme (A) à un seuil, et en cas de dépassement du seuil par le signal déduit du signal somme (A), déclenche un test de fréquences alternatives,
**caractérisé en ce qu'**
on forme un signal basse fréquence proportionnel au signal audio à reproduire, on inverse et on le combine somme (A) et on déclenche un test de fréquences alternatives dès que le signal combiné dépasse la valeur de seuil.

7. Procédé de déclenchement d'un test de fréquences alternatives dans un récepteur radiophonique RDS selon l'une quelconque des revendications 6 ou 7,
**caractérisé en ce qu'**
on déduit les grandeurs de mesure signalant une mauvaise réception du signal HF et/ou des signaux de qualité RDS du décodeur RDS (20).
